# EUROPEAN PATENT SPECIFICATION

(11) **EP 3 796 366 B1**
(45) Date of publication and mention of the grant of the patent: **30.10.2024**
(21) Application number: 20197349.2
(22) Date of filing: 22.09.2020
(51) Int. Cl.: H01L 21/306, C09C 3/04

(54) **A METHOD FOR SURFACE MODIFICATION OF SEMICONDUCTOR NANOPARTICLES USING NON-THERMAL PLASMA ACTIVATED WATER AND PRODUCT THEREOF**
EIN VERFAHREN ZUR OBERFLÄCHENMODIFIZIERUNG VON HALBLEITERNANOPARTIKELN UNTER VERWENDUNG VON NICHT THERMISCH PLASMAAKTIVIERTEM WASSER UND PRODUKT DAVON
PROCÉDÉ DE MODIFICATION DE SURFACE DE NANOPARTICULES SEMI-CONDUCTRICES UTILISANT DE L'EAU ACTIVÉE PAR PLASMA NON THERMIQUE ET UN PRODUIT DE CELLE-CI

(30) Priority: 23.09.2019 LU 101406
(43) Date of publication of application: 24.03.2021
(73) Proprietor: Fyzikální ústav AV CR, v.v.i., 18221 Praha 8 (CZ)
(72) Inventor: Galár, Pavel, 162 00 Praha 6 (CZ); Kusová, Katerina, 162 00 Praha 6 (CZ); Fucíková, Anna, 162 00 Praha 6 (CZ); Khun, Josef, 166 28 Praha (CZ)
(74) Representative: Bauer, Karel

(56) References cited:
- CZ-A3- 2 019 600
- US-A1- 2018 133 680
- US-A1- 2018 244 988
- MARIOTTI D ET AL: "Silicon Nanocrystals in Liquid Media: Optical Properties and Surface Stabilization by Microplasma-Induced Non-Equilibrium Liquid Chemistry", ADVANCED FUNCTIONAL MATERIALS WILEY-VCH VERLAG GMBH GERMANY, vol. 22, no. 5, 7 March 2012 (2012-03-07), pages 954 - 964, XP002801967, ISSN: 1616-301X

## Description

### Technical field

The present invention concerns material science. In particular, it pertains to microstructural technology and nanotechnology. More in particular, the invention relates to the treatment of nanoparticles surface by non-thermal plasma activated water. The invention relates to a process for tailoring the surface chemistry and improving the physical properties of semiconductor nanoparticles.

### Background of the invention

Semiconductor nanoparticles are an emerging class of material with a wide range of application prospects. In contrast to their macroscopic alternatives, properties of the nanomaterials can be significantly tailored via suitable modification of their surface chemistry and size. The modification of nanoparticles' surface is crucial, since it influences their reactivity, solubility in various types of solvents, biocompatibility and biodegradability, optical properties, thermal conductivity, etc. Therefore, new methods of surface modification of nanoparticles are highly required, especially if they involve mild ambient conditions and inexpensive equipment.

There are many ways to engineer and modify the surface chemistry of nanoparticles. Perhaps the most common ones are the wet-chemistry methods that can be initiated by various processes (thermally, radically induced, using microwave or laser irradiation, etc.). However, significant attention is being given to a new class of surface modification procedures involving the exploitation of a plasma treatment, which can be either thermal or non-thermal.

Non-thermal plasma (NTP), which is also called the non-equilibrium or cold plasma, is an ionized gas created typically by electrical discharges. In contrast to hot plasma, NTP possesses the following features: (a) the energy delivered to the discharge is predominantly used for the generation of electrons and (b) there is only a limited transfer of momentum between electrons and heavy particles. Therefore, the electrons show high temperature reaching tens of thousands of Kelvins, while the temperature of the ions and neutral particles is usually near to or a little above the ambient temperature. Nevertheless, the electron energy distribution is still close to the thermal distribution. These conditions determine the main characteristics and performance of non-thermal plasma [1, 2].

Ionization and chemical processes induced by non-thermal plasma are related to the electron energy with approximately units of eV and the used atmosphere (air, nitrogen, oxygen, helium, hydrogen or argon). The collisions of these electrons with other particles result in, in the case of ambient atmosphere, the creation of reactive species (e.g. reactive oxygen species - ROS (i.e. OH·, OH⁻, ozone Os, etc.), reactive nitrogen species - RNS (i.e. NOx, N⁺, etc.)), charged particles and electromagnetic radiation ranging mainly from the ultraviolet to the visible spectral region [3]. Plasma generated at the atmospheres of noble gasses lacks the oxygen and nitrogen reactive species. The properties of the NTP are also affected by the way of discharge generation. In particular, the apparatus composition and the continuous/pulse regime. Typical plasma generation techniques are direct-current corona discharge, dielectric barrier discharge, microwave and gliding discharge, and plasma jets systems [3].

One specific application of NTP is the generation of the so-called plasma activated water (PAW), which is due to its antibacterial effects also known as dead water [3]. In order to create PAW, the NTP experimental setups need to be modified in the way that the discharge burns against the water surface (the plasma jet is directed against water or water is used as a counter electrode). The NTP treatment of pure water is followed by several processes which form the resulting properties and chemical composition of PAW: (*i*) water absorbs a stream of reactive species, which accompany the generation of plasma in the used atmosphere, (*ii*) the impact of high energy electrons on the water molecules causes the generation of water-related reactive species, (*iii*) a mutual reaction of reactive species from (*i*) and (*ii*)*.* The typical reactive species of PAW generated under the atmosphere containing nitrogen and oxygen are: hydrogen peroxide H₂O₂, ozone O₃; nitrogen oxides NOₓ⁻, which can subsequently cause the formation of HNO₂ and HNO₃ acids; or peroxynitrous acid ONOOH in the presence of peroxide. The concentration of these species is dependent on the NTP generation conditions and the composition of the atmosphere.

WO 2016096751 and US 2017001886 disclose systems for the preparation of plasma activated water. In some industrial application, plasma activated water can be used for treating waste water. US 6156114 and US 6383301 disclose a method for treatment of particle surface by plasma activated gas. The solutions are suitable for treating the particles at atmosphere or sub-atmosphere pressure. However, the atmospheric pressure plasma systems are not separately capable to effectively modify material surface by species related to substances that are produced in liquid ambient (e.g. NO₂⁻, NO₃⁻ and ONOOH acids) or their concentration is naturally lower in gas plasma in contrast to PAW (e. g. HNO₂, HNO₃, H₂O₂, OH., OH⁻ and OOH⁻). Moreover, the nanoparticle deagglomeration effects mentioned in the previous patents were related to the ultrasonic pre-treatment and not to the plasma treatment itself. Similarly to these disclosures, D. Mariotti et al. used noble-gas-supplied microplasma setups to create PAW for the modification of nanocrystals [4]. Their methods intentionally avoid the presence of any air-originating oxygen and nitrogen reactive species in PAW. Moreover, the solution does not use pulse discharge for the generation of plasma, which significantly limits the range of the produced reactive species. Taking into account the small effective area of the plasma jet generated by the noble-gas-supplied microplasma apparatus, its industrial exploitation is limited. Here, we need to mention also the inventors' previous work dealing with NTP based ageing (oxidation) of conductive polymer polypyrrole [5]. Even though air-generated transient spark was used for the generation of PAW, the polymer oxidation was realized under different conditions (e.g. cuvette, magnitude of current in pulse, chemical composition of PAW etc.). To modify more complex and surface sensitive materials such as semiconductor nanoparticles, the PAW composition needed to be optimized. In accordance with the results of [5], there will be significantly low RNS binding on the nanoparticle surface. Thus, the application of PAW prepared according to [5] on semiconductor nanoparticles would lead in the best case only to the oxidation of the nanoparticle's surface (can be done by several other well-established methods), or possibly even to their destruction. The main problem is the high concentration of ROS at the expense of other reactive species, especially NO₂⁻ and NO₃⁻. In particular, high concentration of hydrogen peroxide can etch several important types of nanoparticles (e.g. Si). The domination of ROS would also limit surface functionalization of nanoparticles by other species. The domination of ROS would also limit the surface functionalization of nanoparticles by other species. Furthermore, the energy in current pulse presented in [5] is not sufficient for the generation of some types of bonds (e.g. with NO₂⁻, NO₃⁻). Thus, for exact tailoring of nanoparticle surface terminations, the experimental setup and also the experimental conditions needed to be significantly modified. Moreover, the procedure presented in [5] is suitable only for a limited amount of polymer which can be modified at once, while there are several other methods capable of the polymer oxidation (e.g. chemical, thermal).

Non-patent literature MARIOTTI D ET AL, "Silicon Nanocrystals in Liquid Media: Optical Properties and Surface Stabilization by Microplasma-Induced Non-Equilibrium Liquid Chemistry", ADVANCED FUNCTIONAL MATERIALS VILEY-VCH VERLAG GMBH GERMANY, (20120307), vol. 22, no. 5, ISSN 1616-301X, pages 954 - 964, XP002801967 discloses the surface activation of silicon nanoparticles in water irradiated by a plasma or argon.

### References to non-patent literature

[1] Friedman, A. Introduction to Theoretical and Applied Plasma Chemistry in Plasma Chemistry, Chapter 1-11, Cambridge University Press, Great Britain, 2008.
[2] Tendero, C., Tixier, C., Tristant, P., Desmaison, J. Spectrochim. Acta B (2006), 61, 2-30.
[3] Scholtz, V., Pazlarova, J., Souskova, H., Khun, J. and Julak, J. Biotechnol. Adv. (2015), 33, 1108-19.
[4] Mariotti, D., Svrcek, V., Hamilton, W. J., Schmidr. M. and Kondo M. Adv. Funct. Mater. (2012), 22, 954-964
[5] Galar, P., Khun, J., Kopecky, D., Scholtz, V., Trchova, M., Fucikova, A., Jiresova, J. and Fiser L. Sci. Rep. (2017), 7, 15068.

### Summary of the invention

It is an object of the present invention to provide a solution to the technical problem of effective tailoring of semiconductor's nanoparticle surface chemistry.

According to a first aspect of the present invention, a method for surface treatment of semiconductor nanoparticles is provided. The method, according to the present invention, provides an easy and inexpensive way to create a new nitrogen-based surface termination of semiconductor nanoparticles. The restructuring of the surface is done by exposing the surface to reactive oxygen and nitrogen species dissolved in plasma activated water during the exposure to non-thermal plasma.

The method comprises the steps of:
i. providing water;
ii. adding the semiconductor nanoparticles into the water, thereby forming a suspension;
iii. exposure of the suspension by a non-thermal plasma pulse forming plasma activated water modifying the semiconductor nanoparticles therein, wherein the non-thermal plasma is provided under atmosphere comprising at least oxygen and nitrogen but not noble gas; and wherein peak pulse current of a pulse in equilibrium ranges from 5 A to 20 A measured by oscilloscope of 20 MHz bandwidth.

The invention as defined-above provides the surface modification of semiconductor nanoparticles by plasma-activated water, which contains the products of reactive oxygen and nitrogen reactive species. During the modification, the surface of the nanoparticles, dispersed in plasma-activated water, is exposed to an environment which can be represented by:
I. air or another surrounding gas related reactive species that are created during the plasma generation; and
II. water related radical species created by the impact of high energy electrons from NTP; and
III. products of chemical reactions between species from (I) and (II).

The procedure can be carried out at ambient conditions (temperature and air atmosphere) such as standard laboratory condition 25°C and 101,3 kPa in air or using an artificial mixture of nitrogen and oxygen in various ratios (with or without a small additional portion of other compounds, preferably with organic compound, more preferably methane) or any other gasses of reasonable elemental composition (especially nitrogen, oxygen and carbon). There is an exception from atmosphere composition. The exception applies to noble gasses, which prevent the creation of nitrogen related species. In accordance with the present invention, the solution provides further synergic technical advantage, which consists of the optimization of the composition of PAW, in particular, in increase in the concentration of RNS (e.g. NO₂⁻) at the expense of ROS (Table 1). In more particular, the present invention avoids high concentration of hydrogen peroxide, which decreases RNS and etches several important types of nanocrystals headed by Si nanostructures. The present invention provides further synergic technical effect in binding the nitrogen related species on nanoparticles, which is due to a change in the structure of impedance system increasing the energy in pulse and optimizing the amount of the resulting suspension to the shape of a quartz cuvette.

The equilibrium peak pulse current of a discharge ranges from 5 A to 20 A under ambient atmosphere. The temporal dependence of electric current was verified by a standard laboratory oscilloscope using 20 MHz bandwidth. The magnitude of the peak pulse current increased from 2 A to the presented equilibrium value during the modification, which is caused by the radicalization of ambient atmosphere and water and an efficient transfer of air related radical species to the PAW. The presented range of peak pulse current takes into account the fact that a low value of peak pulse current significantly decreases the creation of ROS and RNS and their transfer to water, which would shift the PAW composition to the state not favourable for the modification of semiconductor nanoparticles (e.g. high concentration of H₂O₂ and at the same time low concentration of NOₓ). Too high current could cause electric leaking through the edges of the used cuvettes and heating up of the water.

In a preferred embodiment, the length of the pulse at full width in half maximum is from 40 ns to 200 ns. The length of the pulse at FWHM contributes to better properties of PAW as mentioned above.

In a preferred embodiment, the non-thermal plasma pulse jet is generated using the positive transient spark technique.

In contrast to the continuous discharge generation techniques, the pulse regime of transient spark is capable of transferring large amounts of energy in short time, the preferred parameters are pulse length of 50 ns and peak pulse current of 10 A (measured with oscilloscope of 20 MHz bandwidth). This regime does not only increase the efficiency of the generation of specific ROS and RNS (in particular, atomic oxygen and nitrogen) and their transfer to the water, but also allows the cooling of the water between pulses during its activation.

In another preferred embodiment, the nanoparticles are pre-treated in the dry-powder form using plasma generated by atmospheric-pressure air direct-current positive-corona discharge. Taking into account the nature of the nanoparticle surface activation, mentioned pre-treatment can be realized even at higher or lower pressure conditions. However, it is not necessary and following the idea of low-cost technique, the atmospheric-pressure condition is preferable for the below-mentioned industrial application. This treatment is especially effective using nanoparticles with insufficiently oxidized surface such as fresh Si nanocrystals prepared using the standard chemical or electrochemical techniques.

More preferably, passing current of the direct-current positive-corona discharge ranges from 0.05 mA to 0.5 mA. The range of the passing current magnitudes follows the same idea as was already mentioned for the transient spark discharge.

More preferably, the pre-treatment is at least 60 minutes, even more preferably not more than 300 minutes long. While the corona discharge is less effective in nanoparticle modifications than the pulse regime based plasma, the time intervals for an efficient surface activation need to be longer than in the case of the transient spark technique. Only negligible changes of nanoparticle surface properties were observed at times exceeding 300 minutes.

In another preferred embodiment, a flow of the atmosphere or a mixture of gasses excluding noble gasses is used during the transient-spark generation as the source of the specific reactive species for the plasma activated water.

In another preferred embodiment, the suspension is homogenized, preferably using an ultrasonic pulse homogenizer. The ultrasonic treatment decreases the clustering effect of the nanoparticles, which increases the effective surface of the nanoparticle ensemble and thus the efficiency of the following modification. It was proved that high energy ultrasonic pulses are more effective in breaking up the nanoparticle clusters in contrast to a standard ultrasonic bath.

In another embodiment, the exposure to the transient spark generated plasma is at least 30 seconds, preferably not more than 60 minutes. The preferred embodiment leads to the increase in nitrites and nitrates bonded to the surface of the treated nanoparticles, which in turn positively influence their dispersibility in water, cause deagglomeration and, if the nanoparticles are luminescent, this change in surface chemistry improves their luminescence properties.

In another embodiment, the concentration of the nanoparticles in the plasma activated water is between 0.5 mg/2 ml and 2 mg/2 ml. This concentration range is a compromise between the modification efficiency and the time demands of the experiment. The nanoparticles can be modified using a lower concentration; however, it would be impractical for mass application (time consuming). It was observed that exceeding the concentration of 2 mg/ 2 ml dramatically decreases the modification efficiency.

More preferably, the step of providing water is providing deionized water.

In an alternative technical solution, another method for surface modification of semiconductor nanoparticles is provided. The method comprises the steps of:
iv. providing water;
v. exposure of water to non-thermal plasma, continuous discharge or pulse plasma, forming plasma activated water, wherein the non-thermal plasma is provided under atmosphere comprising at least oxygen and nitrogen but not noble gas;
vi. mixing the semiconductor nanoparticles with the plasma activated water provided in step v.

The alternative method provides an easy and inexpensive way to create a new surface termination of semiconductor nanoparticles. The restructuralization of the nanoparticles surface provide a modification by only the long-living reactive species in the plasma activated water. The long-living reactive species are for example the ozone O₃, NO₂⁻ and NO₃⁻ species. According to this alternative solution, a separate delivery of semiconductor particles and plasma-activated water can be an advantage. In particular, the semiconductor nanoparticles are treated only when it is needed, e.g. before a delivery to a biological material.

In another embodiment compatible with anyone of the above-mentioned solutions, the semiconductor nanoparticles are selected from the group consisting of: ZnO, MgO, ZnS, preferably Si nanoparticles. The Si nanoparticles were chosen as a typical representative of nanoparticles showing efficient quantum confinement originating photoluminescence with a wide range of medical and opto-electronic applications. ZnO and MgO nanoparticles are well defined industrially produced nanostructures showing surface related photoluminescence.

In another embodiment, the suspension of treated nanoparticles is dried to powder.

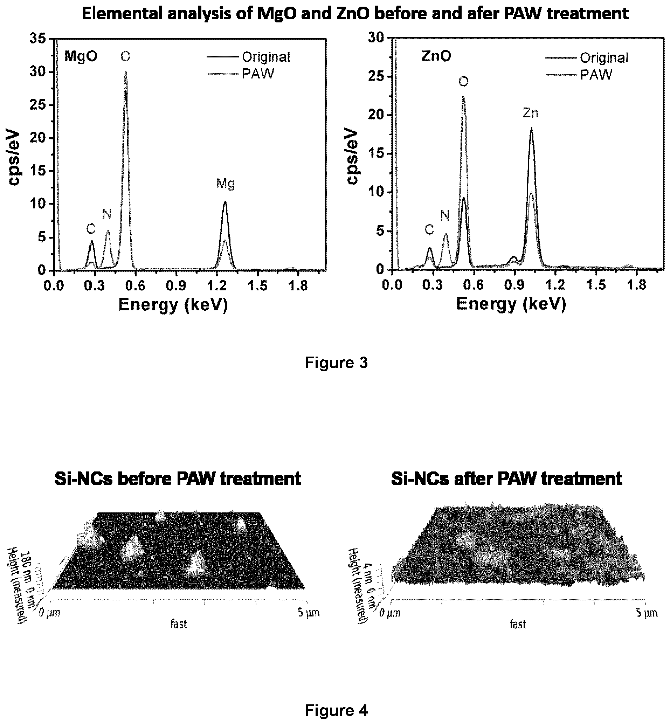

A product by process may be provided. The product exhibits new and improved luminescence properties as shown in Figs. 3 and 4.

The above-described methods may lead to a product by process exhibiting the increase in nitrites and nitrates bonded to the surface of the treated nanoparticles, which in turn positively influence their dispersibility in water, cause deagglomeration and, if the nanoparticles are luminescent, this change in surface chemistry improves their luminescence properties.

### Brief description of the drawing

Fig. 1 represents a system for surface modification of semiconductor nanoparticles using non-thermal plasma activated water.
Fig. 2 represents absorbance spectra of silicon nanocrystals before and after PAW treatment in accordance with the present invention. The data ware obtained using Fourier transformed infrared spectroscopy. Positions and origin of the main bands are indicated.
Fig. 3 represents elemental analysis of magnesium and zinc oxide nanoparticles before and after PAW treatment in accordance with the present invention. The data were obtained by energy-dispersive X-ray spectroscopy. Origins of the main peaks are indicated.
Fig. 4 represents atomic force microscopy characterization of silicon nanocrystal ensemble before and after PAW treatment in accordance with the present invention.
Fig 5a represents photoluminescence spectra of silicon nanocrystals (size ~ 3 nm) with well-oxidized surface before and after PAW treatment in accordance with the present invention. Photoluminescence was excited by continuous laser beam at 325 nm. Power of excitation laser beam is 3.5 mW.
Fig 5b represents photoluminescence spectra of fresh as-prepared silicon nanocrystals (size ~ 3 nm) before and after PAW treatment without the corona discharge pre-treatment. Photoluminescence was excited by continuous laser beam at 325 nm. Power of excitation laser beam is 3.5 mW.
Fig. 5c represents photoluminescence spectra of fresh as-prepared silicon nanocrystals (size ~ 3 nm) before and after PAW treatment with corona discharge pre-treatment. Photoluminescence was excited by continuous laser beam at 325 nm. Power of excitation laser beam is 3.5 mW.
Fig. 6 represents emission spectra of the positive corona discharge and the transient spark discharge. Positions of main peaks: OH radical is at 282 and 309 nm, N₂ ion is at 391.4 nm, 427.8 and 868 nm, N is at 743, 817.7 and 820.6 nm, H is at 656.3 nm and O is at 747, 777 and 844.6 nm. Series of peaks related to N₂ is located approximately from 300 to 500 nm.

### Detailed description of the invention

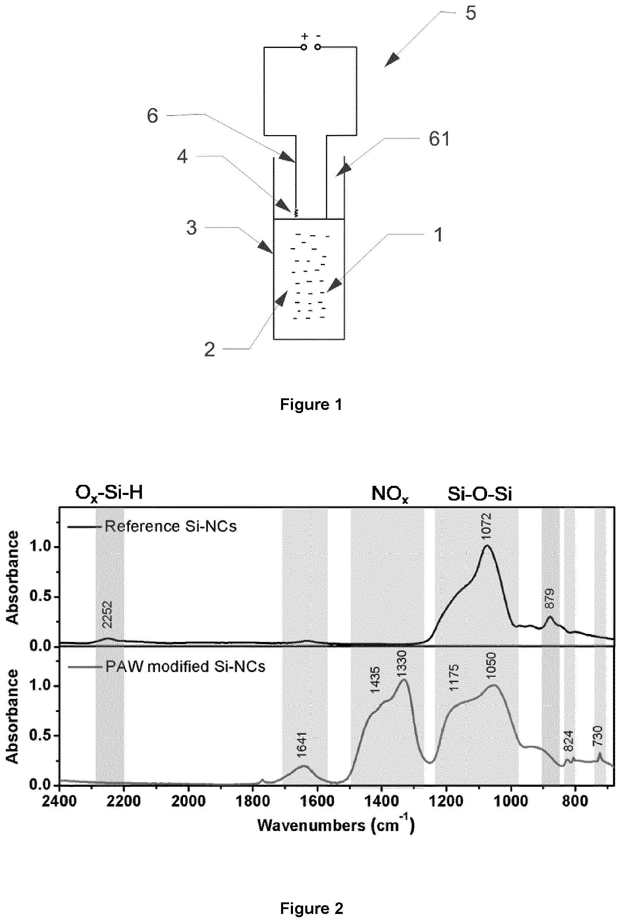

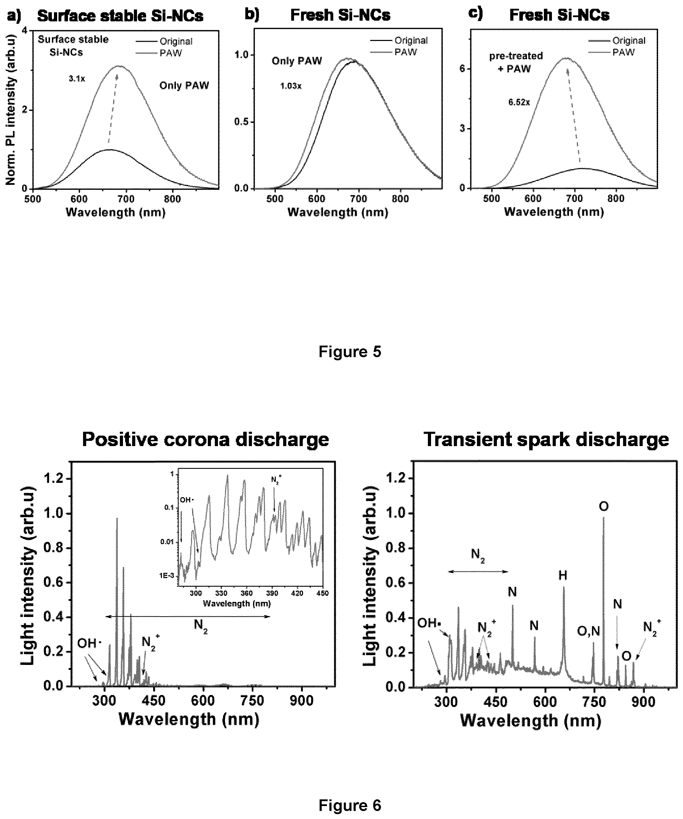

The following example is explained in respect to Fig. 1. For the modification procedure, three examples of semiconductor nanoparticles 1 were chosen, namely the powder of ZnO, MgO or Si nanocrystals. The semiconductor nanocrystals were dispersed in water and placed into a glass cuvette 3. The plasma 4 was generated inside the cuvette 3 using an open air apparatus 5. The discharge burns between a point electrode 6, located several millimeters above the water level, and the water surface. The modification was performed for 30 min. The described procedures lead to the increase in nitrites and nitrates bonded to the surface of the treated nanoparticles **1** and a change of their surface oxidation states (Figure 2 and 3), which in turn positively influence their dispersibility in water, cause deagglomeration (Figure 4) and, if the nanoparticles **1** are luminescent, this change in surface chemistry influences their luminescence properties (improves in the case of Si, Figure 5).

The methods according to the present invention relates to an easy and inexpensive way to create a new surface termination of semiconductor nanoparticles **1.** The restructuring of the surface can be mainly done by exposing the surface to reactive oxygen and nitrogen species dissolved in plasma activated water **2** in three different ways: (a) as-prepared nanoparticles **1** are dispersed in water before the plasma **4** treatment of water and they stay present in the plasma activated water **2** during the discharge burning and after it; (*b*) the method that consist of the process described in (*a*) that is preceded by a pre-treatment of the dry as-prepared nanoparticles **1** by corona discharge in air; (*c*) the nanoparticles **1** are dispersed in water **2** after its activation by non-thermal plasma 4, thus the nanoparticles **1** are modified only by the long-living reactive species in plasma activated water **2.**

In a first embodiment - ad (*a*), the as-prepared dry semiconductor nanoparticles **1** are mixed with pure water. The suspension was treated by an ultrasonic pulse homogenizer for 60 minutes and placed into a quartz/glass cuvette **3** afterwards. The first electrode **6** of the discharge generation system, represented by the tip of a standard syringe needle connected to the positive pole of the power source, is placed a few mm above the water level. The magnitude of the passing discharge electric current can be controlled by changing the distance between the water level and the tip. The surface of the suspension serves as a second electrode, because of the presence of submerged platinum wire **61** (sealed in immersed glass) that is electrically connected with the negative pole of the power source via a stabilizing ballast impedance with parallel connection of 10 MΩ resistor and capacitor of 500 pF (pulse length 50 ns and frequency 2.2 kHz). The resulting transient spark discharge, which is simply a pulse analogy to corona discharge (capable of creating high energy pulses and thus generating a wider spectrum of reactive species - Figure 6), starts to create air plasma **4** and thus high energy electrons and other charged particles, UV light, ozone, reactive oxygen and most importantly nitrogen species that are all directed against the water level. The reaction of plasma **4** containing species with pure water results in the production of plasma activated water **2**, as was already described in detail. The reaction can take between 30 s to 60 minutes, during this time the nanoparticles **1** in liquid are stirred in order to expose the whole sample to non-thermal plasma **4**, and especially the short living species, homogeneously. After this treatment, the surface of the nanoparticles **1** is modified by the above mentioned reactive species and a new termination of the nanoparticle surface is formed. Since there are long term stable reactive species present in the water after the treatment, the modification of the nanoparticle surface can continue for several days. However, while immediate non-thermal plasma **4** treatment in liquid is highly effective, further significant modification of the surface by stable reactive species without the discharge was detected only within sequential few tens of minutes. The representative example of the modification is shown in the Example 1.

In a second embodiment - ad (*b*), to further improve the surface reactivity of dry semiconductor nanoparticles **1** and thus the overall efficiency of the plasma activated water **2** treatment described in (a), the nanoparticles **1** can be pre-treated by corona discharge before mixing with water. This procedure is particularly effective when applied to fresh as-prepared nanoparticles **1** (e.g. Si) which do not have a long-time stable surface termination yet. The DC positive corona discharge was created between two point electrodes **6, 61** using a DC source providing voltage supply in a range of 5 - 10 kV. The electrodes **6, 61** were positioned in the way that the plasma **4** jet was flashing against the dry nanoparticles **1.** To improve the effect of plasma **4** species on the nanoparticles **1**, the nanoparticles **1** were placed in the confined and enclosed space. The reaction takes place between 60 to 300 minutes. The nanoparticles 1 were afterward mixed with water and treated according to the (a), omitting the sonication part that could decrease the reactivity of nanoparticles **1** surface before plasma activated water **2** treatment. The representative example of the modification is shown in the Example 2.

In a third embodiment - ad (c), the nanoparticles **1** were mixed with plasma activated water **2** after finishing the plasma **4** treatment of only water without nanoparticles **1.** While the nanoparticles **1** surface was not in contact with plasma **4**, nanoparticles **1** surface is less reactive. Moreover, they are in contact only with the long-living radical species and their movement is reduced because of the absence of stirring by the plasma **4** jet and a magnetic stirrer. Thus, the reaction is slow and not as effective as the procedures (a) and (b). The significant importance of this embodiment is that the plasma activated water **2** can be transferred independently of nanoparticles **1** and it can be used for the modification of the surface of the nanoparticles **1** subsequently without needing the plasma **4** generation systems **5** at all, which can simplify the method of providing a surface modification of the nanoparticles **1.**

In all cases of non-thermal plasma activated water **2** treatment (a), (b), (c), the surface of the nanoparticles **1** was restructured permanently by the above mentioned reactive species. The change of the surface was clearly observable by standard chemical analytical methods, such as Fourier-transformed infrared spectroscopy (FTIR, Figure 2), energy-dispersive X-ray spectroscopy (EDS, Figure 3 and Table 2) and atomic force microscopy (AFM, Figure 4). FTIR proved a change in the oxidation states of the nanoparticle surface and the presence of NO₂ and NO₃ species, EDS showed the increase of oxygen and nitrogen in ratios ranging from 2-3:1 after the modification, respectively (see Figure 4, Table 2). AFM, as well as simple naked-eye observation, showed significant deagglomeration of the nanoparticles **1** after the treatment. In the case where the non-thermal plasma **4** treated nanoparticles **1** exhibited luminescence such as silicon nanocrystals an increase of photoluminescence (PL) intensity of up to 7 times, a spectral shift towards 700 nm (maximum of the PL band), an increase of the quantum yield of magnitude comparable to the increase of the PL intensity and a decrease of PL time decay were observed, documenting the improved PL properties caused by the surface modification (see Figure 5).

### Example 1:

### Preparation of ZnO, MgO nanoparticles with homogenous surface passivation

The zinc oxide (ZnO) nanoparticles **1** (average size of 14 nm, specific surface 30±5 m²/g and purity > 99 %) were mixed with the pure deionized water in the ratio of 0.5 mg to 2 ml. These nanoparticles **1** exhibit weak luminescence originating from the over band gap charge recombination (band gap of ZnO ~ 3.3 eV) and the red luminescence (band maximum ~ 635 nm) originated from the defects of ZnO surface. The suspension was treated by an ultrasonic pulse homogenizer (overall energy 78kJ) for 60 minutes and placed into a quartz/glass cuvette **3** afterwards. The non-commercial transient spark generation system **5** was set according to the procedure described in the *first embodiment*, i.e. part (a). During the whole non-thermal plasma **4** treatment, the water suspension of nanocrystals, which represent nanoparticles **1,** has been mixed by a magnetic stirrer in order to ensure their homogeneous exposure to the radical plasma **4** species located initially around the water level. The PL intensity and spectra of ZnO nanoparticles **1** was measured in real time. The PL intensity of both bands of the nanoparticles **1** started to dramatically decrease almost immediately with plasma **4** presence. While the one originating from surface defects vanished within few tens of minutes of the treatment, the band related to over band gap charge recombination decreased its intensity about 60 %. The surface chemistry of the modified samples was studied using EDS that proved the increase of nitrogen and oxygen atoms in the ratio of 2-3:1, respectively, which proves the presence of the NO₂ and NO₃ functional groups on the surface of nanoparticles 1 (Table 2). The EDS measurements were realized after proper washing and subsequent drying of the nanoparticles **1**, so the elemental analysis cannot be affected by the artefacts from PAW.

Similar effects were observed also using magnesium oxide (MgO) nanoparticles **1** (average size of 20 nm, specific area 50 m²/g and purity > 99 %). Keeping the experimental conditions used for ZnO, also in this case we have observed a significant decrease of the UV defect related PL of MgO nanoparticles 1. Moreover, EDS measurement proved increased concentration of oxygen and nitrogen in the ratio 2-3:1 after the modification.

### Example 2:

### Surface modification of luminescent silicon nanocrystals

The silicon nanocrystals have been prepared by electrochemical etching. The nanoparticles **1** of silicon nanocrystals have been prepared from the p-type [1,0,0] Si boron doped wafer with resistivity of 0.066-0.100 Ω·cm. The wafer was placed in the etching chamber and submerged in an etching solution consisting of hydrofluoric acid, and ethanol. The etching current density was set to 16 mA/cm². The wafers were etched for 2 hours and the etching solution was mixed continuously for the exclusion of bubbles and homogenization of the etching solution. The etched wafer with a silicon nanocrystal layer on its surface was left to age for a few days in a chamber with controlled temperature and air humidity (around 26 °C and 55 %, respectively). The silicon nanoparticles **1** are then mechanically removed from the silicon wafer and kept in dry conditions. The as-prepared nanoparticles **1** are composed of a silicon crystalline core and silicon oxide shell. Even after prolonged time in air, the surface of silicon nanocrystals is not fully homogeneous, Si-OH, Si-O2, Si-O-Si groups are mostly prevalent on the surface with the presence of dangling bonds. The average luminescence quantum yield of these silicon nanocrystals varies from 8-12%.

To activate the surface of the as-prepared silicon nanocrystals before PAW modification, they were pre-treated by DC positive corona discharge. The plasma **4** was generated by a non-commercial system consisting of two point electrode **6** and standard 5kV DC power source. The electrodes **6, 61** were positioned in a way that the resulting discharge is directed to the silicon powder. The plasma **4** generation was realized at ambient atmosphere without use of any supporting gas. To extend the width of the plasma **4** jet, the discharge was guided to the sample through a metal grating. To improve the effect of plasma **4** species on the nanoparticles 1, the whole system was placed in the confined and enclosed space. The passing current of discharge ranged from 0.05 to 0.5 mA. The activation processes last 240 minutes. The resulting powder was mixed with pure deionized water in a ratio 0.5 mg to 2 ml, respectively, and placed in a quartz/glass cuvette **3.** The suspension was treated by PAW in the same way as was described in Example 1 afterwards.

During the treatment, the PL of the samples increased and spectrally shifted (Figure 5). The resulting increase ranged from 2 to 6.5 times, which was in agreement with the increase of their quantum yield. The PL property improvement of the silicon nanoparticles **1** was also followed by slowing down of (for these kind of material) typical microsecond time decay. In contrast to non-modified silicon nanocrystal mixed with the pure water, treated samples did not show a decrease of PL intensity for more than 1 month. Treated samples also showed significant deagglomeration and the presence of NO₃ species on the surface that was verified by AFM and FTIR, respectively (Figure 2 and 4).

Table 1 provides comparison of pH and concentration of NO₂⁻, NO₃⁻ and H₂O₂ in plasma activated water **2** prepared according to the method described in [5] and the method according to the present invention.

**Table 1**

| **PAW property** | **Apparatus according to [5]** | | **Method according to the present invention** | |
|---|---|---|---|---|
| **pH** | 3 | 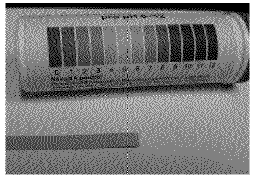 | 1-2 | 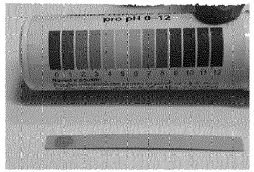 |
| **NO₂⁻ (mg/l)** | 0-1 | 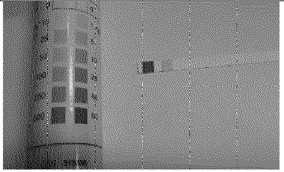 | 30 | 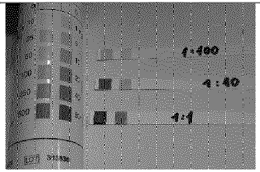 |
| **NO₃⁻ (mg/l)** | 500 | | 5000 | |
| **H₂O₂ (mg/l)** | 150 | 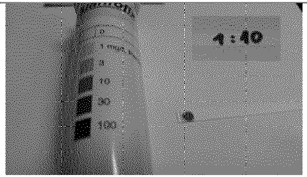 | 0 | 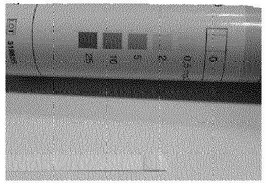 |

Table 2 is providing elemental analysis of repetitive measurements magnesium and zinc oxide nanoparticles **1** before and after PAW treatment obtained by Energy-dispersive X-ray spectroscopy. Indicated are ratio of elemental concentration between zinc and oxygen before and after modification and oxygen and nitrogen obtained during the treatment (corrected to original concentration of oxygen). The same ratios are also presented for magnesium oxide. Presented deviation was calculated as mean deviation.

**Table 2**

| **ZnO nanoparticles** | | | | **MgO nanoparticles** | | |
|---|---|---|---|---|---|---|
| **Area on sample** | **Zn/O** | | **O/N** | **Mg/O** | | **O/N** |
| | Before | After | After | Before | After | After |
| **1** | 0.90 | 0.17 | 2.61 | 0.56 | 0.19 | 2.01 |
| **2** | 0.80 | 0.15 | 2.50 | 0.53 | 0.18 | 2.07 |
| **3** | 0.87 | 0.16 | 2.70 | 0.50 | 0.20 | 2.00 |
| **4** | 0.90 | 0.18 | 2.69 | 0.50 | 0.16 | 1.98 |
| **5** | 0.89 | 0.18 | 2.55 | 0.55 | 0.19 | 2.02 |
| **6** | 0.84 | 0.16 | 2.51 | 0.57 | 0.18 | 1.87 |
| **7** | 0.90 | 0.19 | 2.64 | 0.54 | 0.18 | 1.97 |
| **8** | 0.86 | 0.16 | 2.75 | 0.52 | 0.19 | 2.12 |
| **9** | 0.88 | 0.16 | 2.52 | 0.53 | 0.2 | 2.10 |
| **10** | 0.83 | 0.18 | 2.62 | 0.56 | 0.18 | 2.13 |
| **Average** | 0.87 ± 0.04 | 0.17 ± 0.01 | 2.61 ± 0.09 | 0.53 ± 0.03 | 0.18 ± 0.01 | 2.02 ± 0.08 |

### Industrial applicability

The present invention provides an industrial method for surface modification of semiconductor nanoparticles. Subsequent product can be used for miniaturization of electronic components such as digital watches, calculators, and computers. An alternative industrial applicability can be found in a biotechnology such as bio-labelling of DNA, proteins and cells.

## Claims

1. A method for surface modification of semiconductor nanoparticles (1), wherein the method comprises the steps of:
i. providing water;
ii. adding the semiconductor nanoparticles (1) into the water, thereby forming suspension;
iii. exposure of the suspension to non-thermal plasma (4) pulse, forming plasma activated water (2) modifying the semiconductor nanoparticles (1) therein, wherein the non-thermal plasma (4) is provided under atmosphere comprising at least oxygen and nitrogen but not noble gas; and wherein peak pulse current of in equilibrium ranges from 5 A to 20 A measured with oscilloscope of 20 MHz bandwidth.

2. The method according to claim 1, wherein length of pulse at full width in half maximum is from 40 ns to 200 ns.

3. The method according to claim 1 or 2, wherein the non-thermal plasma (4) pulse is generated by positive transient spark technique.

4. The method according to the preceding claim, wherein the nanoparticles (1) are pre-treated in the dry-powder form using plasma generated by atmospheric-pressure air direct-current positive-corona discharge of 0.05 mA - 0.5 mA average passing current.

5. The method according to claim 4, wherein the pre-treatment is at least 60 minutes, preferably not more than 300 minutes, or time sufficient enough to perform surface modification.

6. The method according to anyone of the preceding claims, wherein a flow of the atmosphere or a mixture of gasses excluding noble gasses is used during the transient-spark generation as the source of the specific reactive species for the plasma activated water (2).

7. The method according to anyone of the preceding claims but not with any combination of claim 4, wherein the suspension mixture is homogenized, preferably by ultrasonic pulse homogenizer.

8. The method according to anyone of the claims 3 to 8, wherein the exposure by transient spark generated plasma (4) is at least for 30 seconds, preferably not more than 60 minutes.

9. The method according to anyone of the preceding claims, wherein concentration of the nanoparticles (1) in the plasma activated water (2) is between 0.5 mg/2 ml and 2 mg/2 ml.

10. The method according to anyone of the preceding claims but not with any combination of claim 4, wherein the step i. of claim 1 is providing deionized water.

11. A method for surface modification of semiconductor nanoparticles 11 (1), wherein the method comprises the steps of:
iv. providing water,
v. exposure of water to non-thermal plasma (4) pulse forming plasma activated water (2), wherein the non-thermal plasma (4) is provided under atmosphere comprising at least oxygen and nitrogen but not noble gas;
vi. mixing the semiconductor nanoparticles (1) with the plasma activated water (2) provided in step v.

12. The method according to anyone of the preceding claims, wherein the semiconductor nanoparticles (1) are selected from the group consisting of: ZnO, MgO, ZnS, preferably Si nanoparticles.

13. The method according to anyone of the preceding claims, wherein the suspension of treated nanoparticles (1) is dried to powder.

## Patentansprüche

1. Ein Verfahren zur Oberflächenmodifikation von Halbleiter-Nanopartikeln oder MgO-Nanopartikeln (1), wobei das Verfahren die folgenden Schritte umfasst:
i. Bereitstellung von Wasser;
ii. Hinzufügen der Halbleiter-Nanopartikel (1) in das Wasser, wodurch eine Suspension entsteht;
iii. Exponierung der Suspension zu einem nicht-thermischen Plasma (4) Impuls, wodurch plasmaaktiviertes Wasser (2) entsteht, das die Halbleiter-Nanopartikel (1) darin modifiziert, wobei das nicht-thermische Plasma (4) unter einer Atmosphäre bereitgestellt wird, die mindestens Sauerstoff und Stickstoff, aber kein Edelgas umfasst; und wobei der Spitzenimpulsstrom im Gleichgewicht von 5 A bis 20 A reicht, gemessen mit einem Oszilloskop mit 20 MHz Bandbreite.

2. Das Verfahren nach Anspruch 1, wobei die Pulsdauer bei voller Breite auf halber Höhe von 40 ns bis 200 ns reicht.

3. Das Verfahren nach Anspruch 1 oder 2, wobei der nicht-thermische Plasma (4) Impuls durch positive Transientfunken-Technik erzeugt wird.

4. Das Verfahren nach dem vorangegangenen Anspruch, wobei die Nanopartikel (1) in Trockenpulverform unter Verwendung von Plasma, das durch atmosphärischen Druckluft-Gleichstrom-positiv-Koronaentladung mit einem durchschnittlichen Durchgangsstrom von 0,05 mA - 0,5 mA erzeugt wird, vorbehandelt werden.

5. Das Verfahren nach Anspruch 4, wobei die Vorbehandlung mindestens 60 Minuten, vorzugsweise nicht mehr als 300 Minuten dauert oder die Zeit ausreicht, um die Oberflächenmodifikation durchzuführen.

6. Das Verfahren nach einem der vorhergehenden Ansprüche, wobei ein Fluss der Atmosphäre oder ein Gasgemisch ohne Edelgase während der Transientfunken-Erzeugung als Quelle der spezifischen reaktiven Spezies für das plasmaaktivierte Wasser (2) verwendet wird.

7. Das Verfahren nach einem der vorhergehenden Ansprüche, jedoch ohne jegliche Kombination von Anspruch 4, wobei die Suspensionsmischung homogenisiert wird, vorzugsweise durch einen Ultraschallpuls-Homogenisator.

8. Das Verfahren nach einem der Ansprüche 3 bis 8, wobei die Exposition durch transienten Funken erzeugtes Plasma (4) mindestens 30 Sekunden, vorzugsweise nicht mehr als 60 Minuten beträgt.

9. Das Verfahren nach einem der vorhergehenden Ansprüche, wobei die Konzentration der Nanopartikel (1) im plasmaaktivierten Wasser (2) zwischen 0,5 mg/2 ml und 2 mg/2 ml liegt.

10. Das Verfahren nach einem der vorhergehenden Ansprüche, jedoch ohne jegliche Kombination von Anspruch 4, wobei der Schritt i. von Anspruch 1 die Bereitstellung von deionisiertem Wasser ist.

11. Ein Verfahren zur Oberflächenmodifikation von Halbleiter-Nanopartikeln oder MgO-Nanopartikeln (1), wobei das Verfahren die folgenden Schritte umfasst:
iv. Bereitstellung von Wasser;
v. Exposition des Wassers zu einem nicht-thermischen Plasma (4) Impuls, wodurch plasmaaktiviertes Wasser (2) entsteht, wobei das nicht-thermische Plasma (4) unter einer Atmosphäre bereitgestellt wird, die mindestens Sauerstoff und Stickstoff, aber kein Edelgas umfasst;
vi. Mischen der Halbleiter-Nanopartikel (1) mit dem in Schritt v. bereitgestellten plasmaaktivierten Wasser (2).

12. Das Verfahren nach einem der vorhergehenden Ansprüche, wobei die Halbleiter-Nanopartikel (1) aus der Gruppe ausgewählt werden, die aus ZnO, MgO, ZnS, vorzugsweise Si-Nanopartikeln besteht.

13. Das Verfahren nach einem der vorhergehenden Ansprüche, wobei die Suspension der behandelten Nanopartikel (1) zu Pulver getrocknet wird.

## Revendications

1. Un procédé de modification de surface des nanoparticules semi-conductrices ou des nanoparticules de MgO (1), le procédé comprenant les étapes suivantes:
i. fournir de l'eau;
ii. ajouter les nanoparticules semi-conductrices (1) dans l'eau, formant ainsi une suspension;
iii. exposer la suspension à une impulsion de plasma non thermique (4), formant de l'eau activée par plasma (2) modifiant les nanoparticules semi-conductrices (1) présentes, le plasma non thermique (4) étant fourni sous une atmosphère comprenant au moins de l'oxygène et de l'azote, mais pas de gaz noble; et le courant de pointe de l'impulsion en équilibre variant de 5 A à 20 A, mesuré avec un oscilloscope de 20 MHz de bande passante.

2. Le procédé selon la revendication 1, dans lequel la durée de l'impulsion à pleine largeur à mi-hauteur est de 40 ns à 200 ns.

3. Le procédé selon la revendication 1 ou 2, dans lequel l'impulsion de plasma non thermique (4) est générée par une technique d'étincelle transitoire positive.

4. Le procédé selon la revendication précédente, dans lequel les nanoparticules (1) sont prétraitées sous forme de poudre sèche en utilisant un plasma généré par une décharge de couronne positive à courant continu sous pression atmosphérique d'air avec un courant moyen passant de 0,05 mA à 0,5 mA.

5. Le procédé selon la revendication 4, dans lequel le prétraitement dure au moins 60 minutes, de préférence pas plus de 300 minutes, ou le temps suffisant pour effectuer la modification de surface.

6. Le procédé selon l'une des revendications précédentes, dans lequel un flux d'atmosphère ou un mélange de gaz sans gaz nobles est utilisé pendant la génération de l'étincelle transitoire comme source d'espèces réactives spécifiques pour l'eau activée par plasma (2).

7. Le procédé selon l'une des revendications précédentes mais pas avec toute combinaison de la revendication 4, dans lequel le mélange de la suspension est homogénéisé, de préférence par un homogénéisateur à impulsions ultrasonores.

8. Le procédé selon l'une des revendications 3 à 8, dans lequel l'exposition au plasma généré par étincelle transitoire (4) dure au moins 30 secondes, de préférence pas plus de 60 minutes.

9. Le procédé selon l'une des revendications précédentes, dans lequel la concentration des nanoparticules (1) dans l'eau activée par plasma (2) est comprise entre 0,5 mg/2 ml et 2 mg/2 ml.

10. Le procédé selon l'une des revendications précédentes mais pas avec toute combinaison de la revendication 4, dans lequel l'étape i. de la revendication 1 consiste à fournir de l'eau déionisée.

11. Un procédé de modification de surface des nanoparticules semi-conductrices ou des nanoparticules de MgO (1), le procédé comprenant les étapes suivantes:
iv. fournir de l'eau;
v. exposer l'eau à une impulsion de plasma non thermique (4), formant de l'eau activée par plasma (2), le plasma non thermique (4) étant fourni sous une atmosphère comprenant au moins de l'oxygène et de l'azote, mais pas de gaz noble;
vi. mélanger les nanoparticules semi-conductrices (1) avec l'eau activée par plasma (2) fournie à l'étape v.

12. Le procédé selon l'une des revendications précédentes, dans lequel les nanoparticules semi-conductrices (1) sont sélectionnées parmi le groupe constitué de: ZnO, MgO, ZnS, de préférence des nanoparticules de Si.

13. Le procédé selon l'une des revendications précédentes, dans lequel la suspension des nanoparticules traitées (1) est séchée en poudre.
